(19) Europäisches Patentamt
European Patent Office
Office européen des brevets

(11) **EP 1 596 478 B1**

(12) **EUROPÄISCHE PATENTSCHRIFT**

(45) Veröffentlichungstag und Bekanntmachung des Hinweises auf die Patenterteilung:
**09.01.2013 Patentblatt 2013/02**

(51) Int Cl.:
***H01R 24/00*** *(2011.01)*

(21) Anmeldenummer: **05010147.6**

(22) Anmeldetag: **10.05.2005**

(54) **Nahendnebensprechverbesserung im Hochfrequenzbereich durch frequenzabhängige Effektivkapazität**

Cross-talk improvement for high frequency by frequency dependent effective capacity

Amélioration de la diaphonie à haute fréquence avec capacité effective dépendante de la fréquence

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **14.05.2004 US 845104**

(43) Veröffentlichungstag der Anmeldung:
**16.11.2005 Patentblatt 2005/46**

(73) Patentinhaber: **Commscope Solutions Properties, LLC**
**Sparks, NV 89431 (US)**

(72) Erfinder:
• **Hashim, Amid**
**Plano, Texas 75093 (US)**
• **Pharney, Julian Robert**
**Indianapolis, Indiana 46236 (US)**

(74) Vertreter: **Patentanwälte Bitterich, Dr. Keller, Schwertfeger**
**Westring 17**
**76829 Landau (DE)**

(56) Entgegenhaltungen:
**GB-A- 2 380 334     US-B1- 6 168 474**
**US-B1- 6 379 157**

**Beschreibung**

Die vorliegende Erfindung betrifft die Nahendnebensprechkompensation (NEXT-Kompensation) in Steckverbindern und insbesondere eine Technik zur Beseitigung oder Reduzierung des NEXT in einem mehrstufig kompensierten System durch Bereitstellung von frequenzabhängiger Effektivkapazität.

Rauschen oder Signalstörungen zwischen den Leitern in einem Steckverbinder sind als Nebensprechen bekannt. Nebensprechen ist bei Kommunikationsvorrichtungen mit Steckverbindern ein verbreitetes Problem. Insbesondere in einem Kommunikationssystem, bei dem ein bei Computern häufig verwendeter modularer Stecker zu einer modularen Buchse passen soll, verursachen die Stromdrähte (Leiter) innerhalb der Buchse und/oder des Steckers Nahendnebensprechen (NEXT), d.h. ein Nebensprechen durch eng nebeneinander angeordnete Drähte über kurze Entfernung. Ein Stecker kann infolge seiner Konfiguration oder der Art und Weise, wie die Leitungen angeschlossen sind, hohes Nebensprechen oder geringes Nebensprechen erzeugen. Ein Stecker mit hohem Nebensprechen wird hier als Hochnebensprechstecker und ein Stecker mit geringem Nebensprechen als Niedrignebensprechstecker bezeichnet.

In dem an Adriaenssens et al. erteilten US-Patent Nr. 5.997.358 wird ein zweistufiger Entwurf zur Kompensation eines solchen NEXT beschrieben. Der gesamte Inhalt des US-Patents 5,997,358 soll durch Bezugnahme zur Offenbarung zählen. Ferner sollen die Gegenstände der US-Patente Nr. 5,915,989; 6,042,427; 6,050,843 und 6,270,381 ebenfalls durch Bezugnahme zur Offenbarung zählen.

Das US-Patent 5,997,358 reduziert das NEXT (Original-Nebensprechen) zwischen den Stromdrahtpaaren eines modularen Steckers durch Hinzufügung eines erzeugten oder künstlichen Nebensprechens, normalerweise im Stecker und in zwei Stufen, wodurch die Nebensprechvorgänge aufgehoben oder das Gesamtnebensprechen für die Stecker-Buchsen-Kombination reduziert wird. Das erzeugte Nebensprechen wird hier als Kompensationsnebensprechen bezeichnet. Diese Idee wird normalerweise durch Anwendung kapazitiver und/oder induktiver Kompensation in zwei Stufen implementiert. Diese Idee kann zum Beispiel dadurch verwirklicht werden, dass sich der Weg eines der Leiter eines der Paare einer zu kompensierenden Paarkombination innerhalb des Steckverbinders zweimal kreuzt, sodass zwei Stufen der NEXT-Kompensation entstehen. Dieser Entwurf ist bei der NEXT-Reduzierung effizienter als ein Entwurf, bei dem die Kompensation in nur einer Stufe erfolgt, insbesondere wenn wie üblich die Kompensation erst nach einer zeitlichen Verzögerung eingeführt werden kann.

Wenngleich effektiv, weist der Entwurf einer NEXT-Kompensation gemäß dem US-Patent 5,997,358 insofern einen Nachteil auf, als der NEXT-Abstand zur Grenzlinie der Telecommunications Industry Association (TIA) bei niedriger Frequenz (unter ca. 100 MHz) unter Verwendung eines Hochnebensprechsteckers mit der Buchse und bei hoher Frequenz (über ca. 250 MHz) unter Verwendung eines Niedrignebensprechsteckers mit der Buchse zurückgeht. Besonders wenn das Nettokompensationsnebensprechen in einer zweistufig gedämpften Buchse geringer ist als bei dem Original-Nebensprechen, d. h. wenn in die Buchse ein Hochnebensprechstecker eingesteckt wird, wird die Stecker-Buchsen-Kombination als unterkompensiert bezeichnet, und die daraus resultierende NEXT-Frequenzkurve wird bei niedrigen Frequenzen eine Spitze erreichen, bevor bei einem Frequenzwert, der von den Verzögerungen zwischen den Stufen und von den Größenordnungen der Kompensationsstufen bestimmt wird, ein Nullpunkt erreicht wird. Dann verändert sich die Flanke der NEXT-Frequenzgangkurve von einer flachen Flanke vor dem Nullpunkt zu einer steilen Flanke hinter dem Nullpunkt, so dass das NEXT bei hohen Frequenzen, d. h. bei Frequenzen jenseits dieser Nullpunkte, schnell verschlechtert wird.

Ist andererseits das Nettokompensationsnebensprechen in einer solchen Buchse stärker als das Original-Nebensprechen, d. h. wenn ein Niedrignebensprechstecker eingesteckt wird, wird die Stecker-Buchsen-Kombination als überkompensiert bezeichnet, und die daraus resultierende NEXT-Frequenzkurve wird keinen Nullpunkt aufweisen, sondern die Flanke der NEXT-Frequenzkurve wird bei sehr hohen Frequenzen mit bis zu 60dB/Dekade ansteigen, und dieser Wert liegt bei weitem über dem TIA-Flankengrenzwert von 20 dB/Dekade.

Während der Niederfrequenzbereich, d. h. die Niederfrequenzeigenschaft des Steckverbinders, bei Verwendung eines Hochnebensprechsteckers mit der Buchse durch Erhöhung des Kompensationsniveaus verbessert werden kann, würde eine solche Maßnahme bei Verwendung des Niedrignebensprechsteckers eine weitere Verschlechterung des Hochfrequenzbereichs, d. h. der Hochfrequenzeigenschaft des Steckverbinders, bewirken. Umgekehrt würde eine solche Maßnahme, während der Hochfrequenzbereich bei Verwendung eines Niedrignebensprechsteckers mit der Buchse durch Reduzierung des Kompensationsgrads verbessert werden kann, zu einer weiteren Verschlechterung des Niederfrequenzbereichs führen, wenn mit der Buchse ein Hochnebensprechstecker verwendet wird.

Ein weiterer Steckverbinder mit induktiver Kompensation ist aus dem US-Patent 6,379,157 bekannt.

Deshalb besteht die Notwendigkeit für eine Technik, die es erlaubt, das NEXT bei hohen Frequenzen, wenn Niedrignebensprechstecker verwendet werden, und bei niedrigen Frequenzen, wenn Hochnebensprechstecker verwendet werden, gleichzeitig zu reduzieren oder zu beseitigen.

Die vorliegende Erfindung überwindet die Probleme und Begrenzungen, die die bekannte Technik zur Reduzierung des NEXT in Steckverbindern mit sich bringt. Die Erfindung beinhaltet insbesondere einen Entwurf für die mehrstufige Nebensprechkompensation, wobei die daraus resultierende kapazitive Kopplung so stabilisiert wird, dass der Gesamtkompensationsgrad bei zunehmender Frequenz abnimmt, wodurch sich die Hochfrequenz-NEXT-Eigenschaft des Steckverbinders ohne Beeinträchtigung der Niederfrequenz-NEXT-Eigenschaft signifikant verbessert. Dies geschieht durch Bereitstellung einer Kompensationsschaltung der Stufe eins mit relativ flachem effektivem Kapazitätsgang bei steigender Frequenz, während bei zunehmender Frequenz eine Kompensationsschaltung der Stufe zwei mit zunehmendem effektivem Kapazitätsgang bereitgestellt wird.

Die Erfindung verbessert sowohl das Nebensprechverhalten bei niedriger Frequenz, z .B. 1 - 100 MHz, als auch das Nebensprechverhalten von modularen Ausgängen und Schalttafeln bei hoher Frequenz, z .B. 250 - 500 MHz oder 500 MHz und darüber.

Diese und andere erfindungsgemäße Eigenschaften gehen aus der nachfolgenden detaillierten Beschreibung deutlicher hervor. Es ist jedoch davon auszugehen, dass die detaillierte Beschreibung und die speziellen Beispiele nur bevorzugte Ausführungsformen der Erfindung darstellen, und lediglich veranschaulichenden Charakter haben und dass sich für den Fachmann aus dieser detaillierten Beschreibung verschiedene Änderungen und Modifikationen ergeben, die im Geist und Anwendungsbereich der Erfindung liegen.

Die Erfindung wird verdeutlicht durch die nachstehende detaillierte Beschreibung und die beigefügten Zeichnungen, die lediglich der Veranschaulichung dienen und somit die Erfindung nicht einschränken. Es zeigen:

Fig. 1    den Aufbau einer erfindungsgemäßen, in Serie geschalteten Induktionsspulen-Kondensator-Kombination,

Fig. 2    eine perspektivische Ansicht einer vereinfachten Leiterplatte, die ein Beispiel dafür zeigt, wie die in Serie geschaltete Induktionsspulen-Kondensator-Kombination gemäß Fig. 1 nach einer ersten Ausführungsform dieser Erfindung implementiert werden kann,

Fig. 3    eine grafische Darstellung eines simulierten Beispiels des Verhältnisses wirksame Kapazität/Frequenzgang des in Fig. 2 abgebildeten Leiterplattenaufbaus,

Fig. 4A    eine Seitenansicht eines Steckverbinders nach einer ersten Ausführungsform der Erfindung,

Fig. 4B    eine Draufsicht auf die Leiterplatte und die NEXT-Kompensationselemente nach Fig.

4A gemäß der ersten Ausführungsform der Erfindung,

Fig. 5    ein Beispiel für den Aufbau eines Interdigitalkondensators gemäß einer zweiten Ausführungsform der Erfindung,

Fig. 6    eine grafische Darstellung eines simulierten Beispiels des Verhältnisses wirksame Kapazität/ Frequenzgang von Interdigitalkondensatoren mit unterschiedlichen Längen-Breiten-Verhältnissen,

Fig. 7A    eine Seitenansicht eines Steckverbinders gemäß der zweiten Ausführungsform der Erfindung,

Fig. 7B    eine Draufsicht auf die Leiterplatte und die NEXT-Kompensationselemente nach Fig. 7A gemäß der zweiten Ausführungsform der Erfindung,

Fig. 8    eine perspektivische Ansicht einer vereinfachten Leiterplatte, die zeigt, wie die in Serie geschaltete Induktionsspulen-Kondensator-Kombination nach Fig. 1 gemäß einer dritten Ausführungsform der Erfindung implementiert werden kann,

Fig. 9    ein Beispiel eines gefalteten Interdigital-Langkondensators gemäß einer vierten Ausführungsform der Erfindung,

Fig. 10    eine perspektivische Ansicht einer vereinfachten Leiterplatte, die zeigt, wie die in Serie geschaltete Induktionsspulen-Kondensator-Kombination nach Fig. 1 gemäß einer fünften Ausführungsform der Erfindung implementiert werden kann,

Fig. 11    eine grafische Darstellung, worin als Beispiel die Verhältnisse wirksame Kapazität/ Frequenzgang der NEXT-kompensierten Leiterplatten gemäß den verschiedenen Ausführungsformen der Erfindung verglichen werden,

Fig. 12A    eine Seitenansicht eines Steckverbinders gemäß einer sechsten Ausführungsform der Erfindung und

Fig. 12B    eine Draufsicht auf die Leiterplatte und die NEXT-Kompensationselemente nach Fig. 12A gemäß der sechsten Ausführungsform der Erfindung.

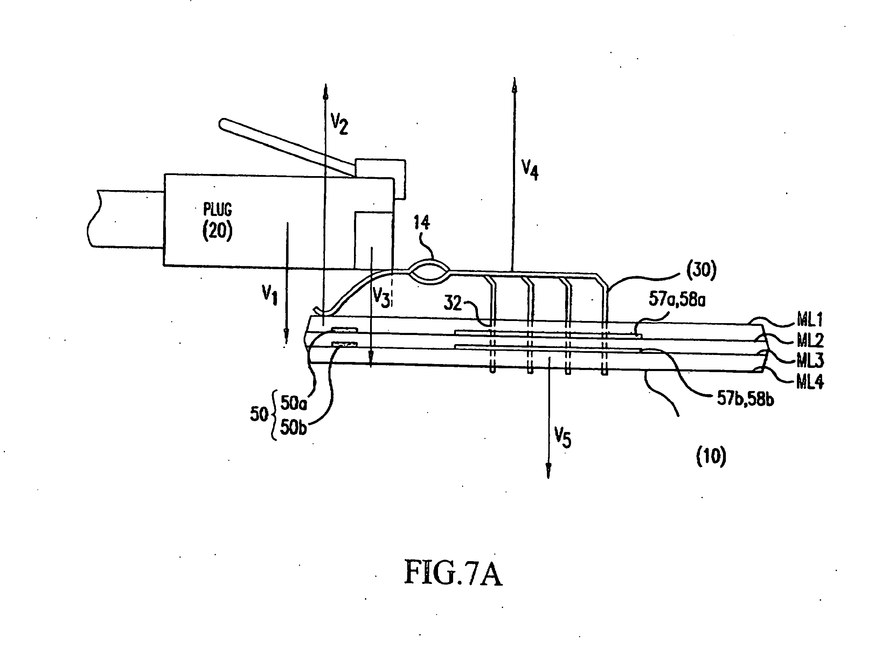

Nunmehr wird im Einzelnen auf die bevorzugten Ausführungsformen der Erfindung Bezug genommen, für die in den beigefügten Zeichnungen veranschaulichende Beispiele enthalten sind. In dieser Anmeldung bezeichnet der Begriff "Stufe" die Stelle einer Kompensation, die an einem Kompensationsverzögerungspunkt auftritt. Die Erfindung offenbart verschiedene Konfigurationen von Leiterplatten, die an die Stelle der Leiterplatte nach Fig. 7A des US-Patents 5,997,358 treten können.

Die Erfindung stellt in einer zweiten Stufe eines mehrstufigen NEXT-Kompensationssystems für einen Steckverbinder eine Kompensationsschaltung bereit. Diese zweite Stufe weist bei zunehmender Frequenz einen steigenden effektiven Kapazitätsgang auf. Dies kann durch Verwendung einer in Serie geschalteten Induktionsspulen(L)-Kondensator(C)-Kombination, eines Interdigitalkondensators mit großem Längen-Breiten-Verhältnis, eines verlängerten, gefalteten InterdigitalKondensators oder von leerlaufenden Übertragungsleitungen innerhalb eines Steckverbinders entsprechend den verschiedenen Ausführungsformen der Erfindung erreicht werden.

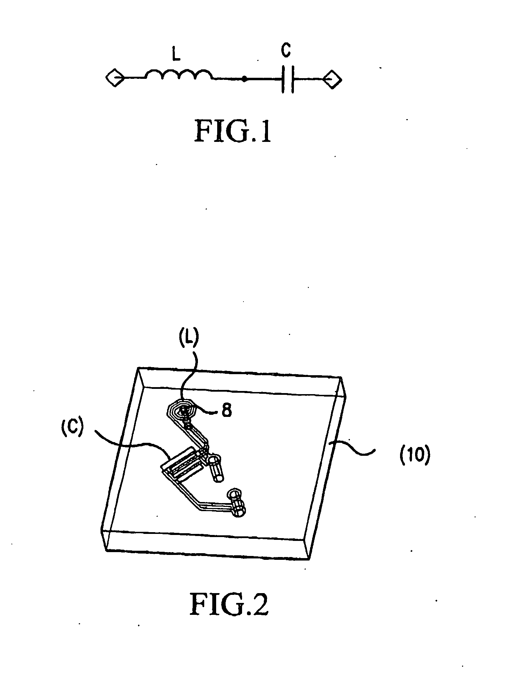

Fig. 1 zeigt einen in Serie geschalteten Aufbau einer L-C-Kombination gemäß einer ersten Ausführungsform der Erfindung. Die Gleichung für die effektive Kapazität ($C_{eff}$) für diese in Serie geschaltete L-C-Kombination lautet wie folgt:

$$Ceff = \frac{C}{1 - (2\pi f)^2 LC}$$

worin f die Frequenz, C die Kapazität des Kondensators und L die Induktiviät der Induktionsspule bezeichnen. Wie aus dieser Gleichung ersichtlich, nimmt mit steigender Frequenz die effektive Kapazität $C_{eff}$ zu, solange die Frequenzen kleiner sind als die Resonanzfrequenz $f_{res}$ der in Serie geschalteten L-C-Kombination. Die Resonanzfrequenz $f_{res}$ wird wie folgt definiert:

$$f_{res} = \frac{1}{2\pi\sqrt{LC}}$$

Gemäß der Erfindung werden L und C so gewählt, dass die Resonanzfrequenz fres oberhalb der höchsten Betriebsfrequenz der interessierenden Bandbreite auftritt. Dadurch kann die effektive Kapazität zunehmen, während die Frequenz bis zur Resonanzfrequenz $f_{res}$ ansteigt.

Fig. 2 zeigt eine perspektivische Ansicht einer vereinfachten Leiterplatte (10), die zeigt, wie die in Serie geschaltete L-C-Kombination nach Fig. 1 gemäß einer ersten Ausführungsform der Erfindung implementiert wird. Einzelheiten der Leiterplatte sind nicht dargestellt. Die Induktionsspule L wird in diesem Beispiel mit einer Spiralspule implementiert, deren Spiralaufbau auf einer Oberfläche der Leiterplatte liegt. Der Kondensator C wird in diesem Beispiel mit einem Kondensatoraufbau implementiert, der aus zwei Interdigitalkondensatoren besteht, die elektrisch parallel geschaltet sind und auf Innenschichten der Leiterplatte liegen. Ein Interdigitalkondensator ist ein Kondensator, bei dem zwei ineinander greifende Metallkämme, jeder mit einem anderen Potenzial, koplanar angeordnet sind, und ist als solcher bekannt. Der Kondensator C ist mit der Induktionsspule L über einen leitenden Verbindungskontakt 8, z. B. ein plattiertes Durchgangsloch, elektrisch verbunden. Zu beachten ist, dass der in Serie geschaltete Kondensator nach Fig. 1 für den Zweck der ersten Ausführungsform dieser Erfindung auch mit einem einfachen Parallelplattenkondensator implementiert werden kann, der auf zwei Schichten der Leiterplatte angeordnet ist.

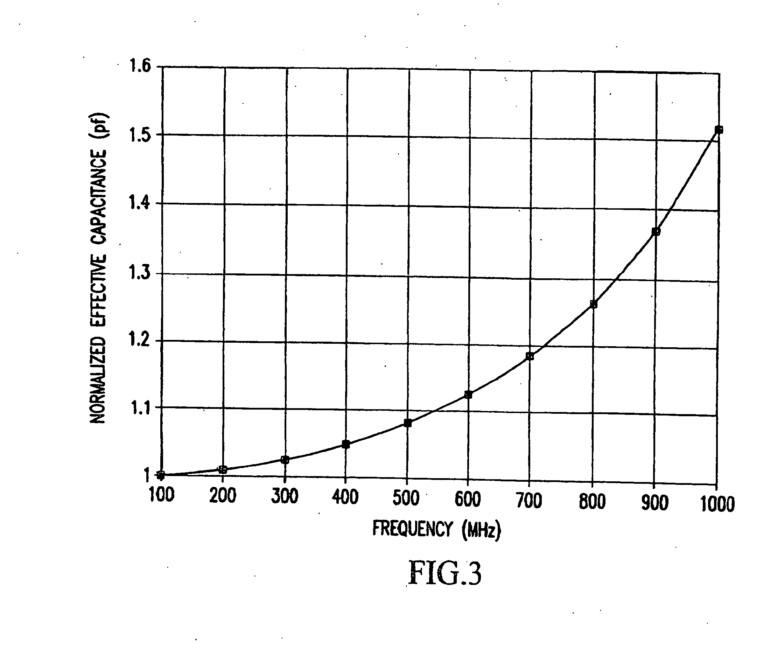

Fig. 3 ist eine grafische Darstellung eines simulierten Beispiels des Verhältnisses effektive Kapazität/ Frequenzgang des in Fig. 2 dargestellten Leiterplattenaufbaus. Diese grafische Darstellung wurde mit Hilfe einer bekannten Simulationssoftware, "hfss", angeboten durch Ansoft, Inc., simuliert. Mit den auf 1 pF bei 100 MHz normierten Kapazitätswerten zeigt die Grafik, dass die effektive Kapazität der in Fig. 2 dargestellten Leiterplatte mit steigender Frequenz zunimmt. Ein ähnlicher Frequenzgang läge vor, würde es sich bei dem Kondensator um einen einfachen Parallelplattenkondensator handeln.

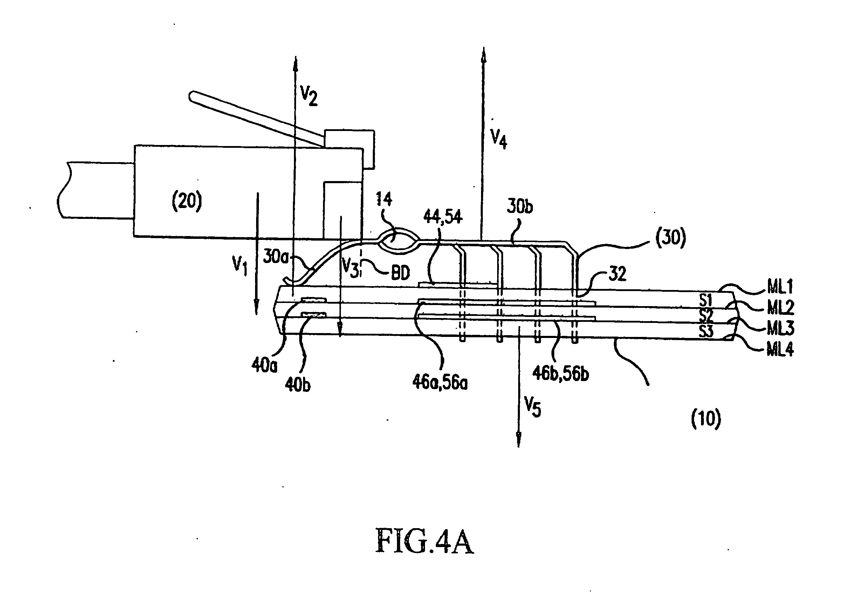

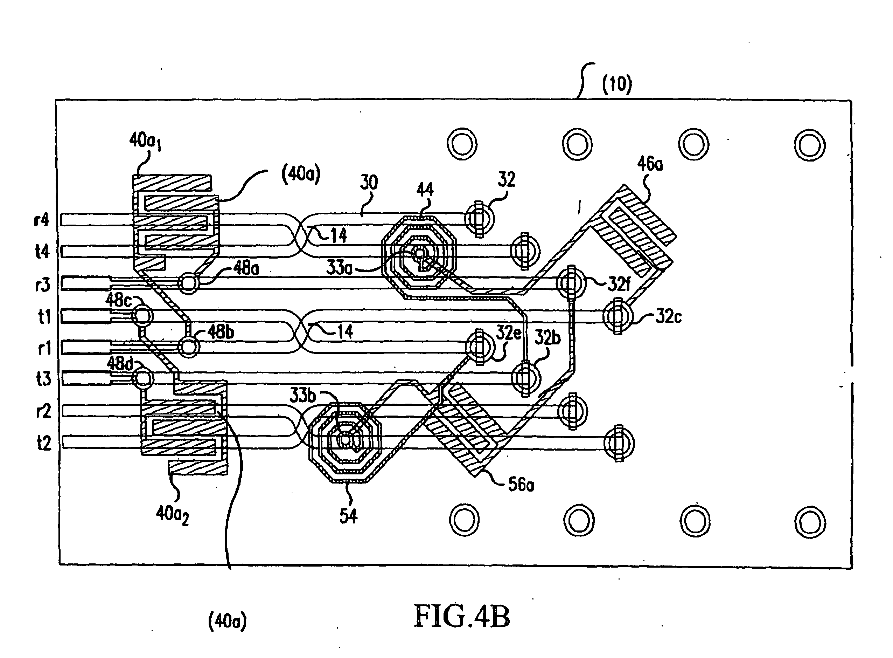

Die Fig. 4A und 4B veranschaulichen, wie die Schaltungsanordnung der in Serie geschalteten L-C-Kombination gemäß der ersten Ausführungsform für die 1-3-Paar-NEXT-Kompensation in einem Steckverbinder eingesetzt wird. Fig. 4A ist eine Seitenansicht eines Steckverbinders gemäß der ersten Ausführungsform der Erfindung und Fig. 4B eine Draufsicht auf die Leiterplatte und die NEXT-Kompensationselemente nach Fig. 4A.

In den Fig. 4A und 4B weist der Steckverbinder Federkontakte 30 mit Überkreuzungen 14 und eine Leiterplatte 10 auf. Ein Stecker 20 soll mit dem Steckverbinder zusammenpassen. Der Stecker 20 kann ein modularer Stecker von der Art sein, die am Ende einer Telefonleitung oder eines Steckerkabels für den Anschluss eines PC an eine Datensteckdose verwendet wird. Die Kontakte 30 können in plattierte Durchgangslöcher 32 in den entsprechenden Abschnitten der Leiterplatte 10 eingelötet oder eingepresst sein, und es kann sich dabei um Federdrahtkontakte handeln. Überdies weisen die Kontakte 30 einen Strom führenden Abschnitt 30b und einen nicht Strom führenden Abschnitt 30a auf, wobei in Fig. 4A zwischen diesen Abschnitten 30a und 30b eine Grenze BD angegeben ist. Die Kontakte 30 und die Leiterplatte 10 können in einem Gehäuse, z. B. einer modularen Buchse, untergebracht sein, so dass beim Einstecken des Steckers 20 in die Buchse die elektrischen Kontakte an dem Stecker 20 über die Kontakte 30 mit den elektrischen Kontakten der Leiterplatte 10 koppeln.

Die Leiterplatte 10 ist eine Mehrlagenleiterplatte aus Harz oder einem Material, dessen Eignung als Leiterplattenmaterial bekannt ist. In diesem Beispiel besteht die Leiterplatte 10 aus drei Substraten (S1-S3) und vier metallischen Schichten (ML1-ML4), die abwechselnd gestapelt sind. Im Einzelnen werden die Substrate und die metallischen Schichten in nachstehender Reihenfolge (von oben nach unten) übereinander angeordnet: ML1, S1, ML2, S2, ML3, S3 und ML4. Die metallischen Schichten ML1-ML4 bilden jeweils leitende Muster, die auf der Oberfläche des Substrats unmittelbar unterhalb der korrespondierenden metallischen Schicht ausgebildet sind. Bestimmte Teile der metallischen Schichten sind für den elektrischen Anschluss über einen oder mehrere leitende Verbindungskontakte 32 wie plattierte Durchgangslöcher miteinander verbunden. Die dargestellten Federkontakte 30 befinden sich oberhalb der ersten metallischen Schicht ML1.

Bei den Federkontakten 30 kann es sich um eine Mehrzahl von Drahtpaaren P handeln, von denen jedes Paar P Kontakte aufweist, die als Minuspol (r) und Pluspol (t) bezeichnet werden. In Fig. 4B sind vier Paare vorgesehen und es handelt sich dabei um t1, r1; t2, r2; t3, r3 und t4, r4. Minus bedeutet bekanntermaßen negativ gepolt und Plus positiv gepolt.

Erste und zweite Paare von Interdigitalkondensatoren 40a und 40b, die der kapazitiven Kompensation für die NEXT-Kompensation der Stufe eins dienen, sind jeweils auf der zweiten und dritten metallischen Schicht ML2 bzw. ML3 der Leiterplatte 10 ausgebildet oder bilden einen Teil davon. In diesem Beispiel sind die Kontaktfedern in einem Abschnitt 30b hinter der Überkreuzung 14 angeordnet, um als Teil der ersten Kompensationsstufe zur induktiven Kompensation beizutragen. Das erste Paar von Interdigitalkondensatoren 40a auf der zweiten Schicht ML2 ist auf der dritten Schicht ML3 als zweites Kondensatorenpaar 40b dupliziert. Das erste Paar von Interdigitalkondensatoren 40a besteht aus den Kondensatoren $40a_1$ und $40a_2$, die beide auf der zweiten Schicht ML2 angeordnet sind. Das zweite Paar von Interdigitalkondensatoren 40b besteht aus den Kondensatoren $40b_1$ und $40b_2$, die beide auf der dritten Schicht ML3 angeordnet sind. Die Enden des ersten Kondensators $40a_1$ im ersten Paar stehen über ein Paar plattierter Durchgangslöcher 48a und 48b mit den Minuspolen r3 bzw. r1 in elektrischem Kontakt. Die Enden des zweiten Kondensators $40a_2$ im ersten Paar stehen über ein Paar plattierter Durchgangslöcher 48c, 48d mit den Pluspolen t1 bzw. t3 in elektrischem Kontakt. Das zweite Paar von Interdigitalkondensatoren 40b bilden die Kondensatoren $40b_1$, $40b_2$, die beide in gleicher Weise wie das erste Paar von Interdigitalkondensatoren 40a auf der dritten Schicht ML3 angeordnet sind. Über plattierte Durchgangslöcher 48a, 48b sind die Kondensatoren $40a_1$, $40b_1$ elektrisch parallel geschaltet. In ähnlicher Weise sind die Kondensatoren $40a_2$, $40b_2$ über plattierte Durchgangslöcher 48c, 48d elektrisch parallel geschaltet. Des Weiteren sind auf der Leiterplatte 10 Schaltungsanordnungen einer in Serie geschalteten L-C-Kombination vorgesehen, die als NEXT-Kompensationsschaltungen der Stufe zwei dienen. Die erste Schaltungsanordnung einer in Serie geschalteten L-C-Kombination weist eine Spiralspule 44 sowie erste und zweite Interdigitalkondensatoren 46a und 46b auf. Die Spiralspule 44 ist auf oder über der ersten metallischen Schicht ML1 angeordnet, wohingegen die ersten und zweiten Interdigitalkondensatoren 46a, 46b auf der zweiten bzw. dritten metallischen Schicht ML2, ML3 angeordnet sind. Auf ähnliche Weise umfasst die zweite Schaltungsanordnung einer in Serie geschalteten L-C-Kombination eine Spiralspule 54 sowie dritte und vierte Interdigitalkondensatoren 56a und 56b. Die Spiralspule 54 ist auf oder über der ersten galvanisierten Schicht ML1 angeordnet, wohingegen die dritten und vierten Interdigitalkondensatoren 56a, 56b auf der zweiten bzw. dritten metallischen Schicht ML2, ML3 angeordnet sind. In diesem Beispiel sind die ersten und dritten Kondensatoren 46a, 56a der Schicht ML2 auf der Schicht ML3 als zweite bzw. vierte Kondensatoren 46b, 56b angeordnet. Über plattierte Durchgangslöcher 33a, 32c sind die Kondensatoren 46a, 46b elektrisch parallel geschaltet. Über plattierte Durchgangslöcher 33b, 32f sind die Kondensatoren 56a, 56b elektrisch parallel geschaltet.

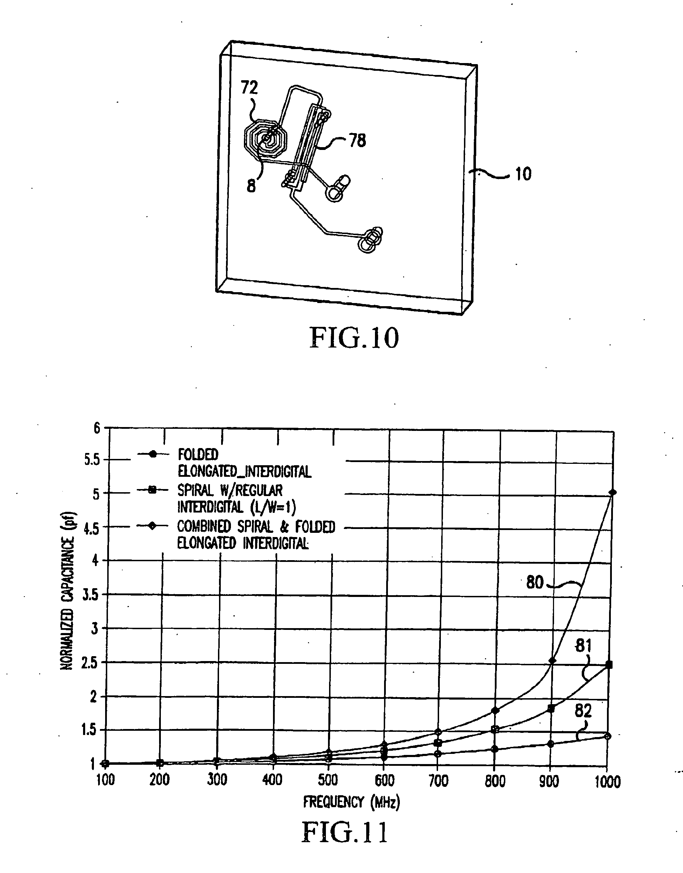

Im Rahmen dieser Anmeldung bezeichnet der auf die Kompensationskondensatoren angewandte Begriff "dupliziert" die identische Ausführung auf allen genannten metallischen Schichten. Die Kondensatoren 40a beispielsweise hätten eine identische Form und Größe und wären vertikal ausgerichtet mit den Kondensatoren 40b. Grund für die Duplizierung der Interdigitalkondensatoren ist eine Erhöhung der Kapazität, ohne die Grundfläche (abgedeckte Fläche) vergrößern zu müssen. Interdigitalkondensatoren mit einer größeren Grundfläche könnten auch ohne Notwendigkeit einer solchen Duplizierung verwendet werden. Würde die Leiterplatte andererseits mit mehr metallischen Schichten ausgeführt, können die Interdigitalkondensatoren auf mehr als zwei metallischen Schichten dupliziert werden, um die Grundfläche, wenn gewünscht, kleiner zu machen. Zu beachten ist, dass im Sinne der ersten Ausführungsform anstelle der Interdigitalkondensatoren 46a, 46b, 56a und 56b Parallelplattenkondensatoren verwendet werden könnten. Bei den Kondensatoren 40a, 40b der ersten Stufe könnte es sich auch um Parallelplattenkondensatoren gehandelt haben, wie sie z. B. gemäß Fig. 10, die weiter unten besprochen wird, verwendet werden.

Die Spule 44 wird mit jedem der ersten und zweiten Interdigitalkondensatoren 46a, 46b über das plattierte Durchgangsloch 33a in Serie geschaltet. Ein Ende der Spule 44 ist über ein plattiertes Durchgangloch 32b mit dem Pluspol t3 elektrisch verbunden. Ein Ende jedes der ersten und zweiten Kondensatoren 46a, 46b ist über das plattierte Durchgangsloch 32c mit dem Minuspol r1 elektrisch verbunden. Auf ähnliche Weise ist die Spule 54 über den leitenden Verbindungskontakt 33b mit jedem der dritten und vierten Interdigitalkondensatoren 56a, 56b in Serie geschaltet. Ein Ende der Spule 54 ist über das plattierte Durchgangsloch 32e mit dem Pluspol t1 elektrisch verbunden. Ein Ende jedes der dritten und vierten Kondensatoren 56a, 56b ist über das plattierte Durchgangsloch 32f mit dem Minuspol r3 elektrisch verbunden.

Gemäß der Erfindung verbessert die Verwendung einer in Serie geschalteten L-C-Kombination für die NEXT-Kompensation der zweiten Stufe einer zweistufigen Kompensationslösung, die in diesem Beispiel für die 1-3 PaarKombination dargestellt ist, die Eigenschaften bei hohen Frequenzen, wenn der Stecker 20 ein Niedrignebensprechstecker ist, und verbessert die Eigenschaften bei niedrigen Frequenzen, wenn der Stecker 20 ein Hochnebensprechstecker ist. Die Erklärung hierfür lautet wie folgt.

NEXT, d. h. Nahendnebensprechen, wird auf zwei Faktoren zurückgeführt: kapazitive Kopplung und induktive Kopplung. Die große Nähe von zwei Drähten bewirkt eine kapazitive Kopplung, wohingegen der durch diese Drähte fließende Strom eine induktive Kopplung bewirkt. Der Stecker 20 führt somit beim Verbinden mit den Kontakten 30 sowohl die kapazitive Kopplung als auch die induktive Kopplung herbei. Beide Faktoren tragen zur Erzeugung des Nahendnebensprechens oder NEXT bei.

Für die NEXT-Reduzierung oder -Kompensation werden im Allgemeinen zwei Kompensationsstufen verwendet. Die erste Stufe wird in Gegenphase zum Stecker-NEXT gebracht, während die zweite Stufe in Gleichphase zum Stecker-NEXT gebracht wird. Dies ist bekannt und in dem US-Patent 5,997,358 offenbart. Die Richtung der Kompensation im Verhältnis zu derjenigen des Steckers ist in Fig. 4A zur Veranschaulichung mit den Pfeilen V1 bis V5 bezeichnet.

Ebenso wird Nebensprechen, welches am fernen Ende eines Steckverbinders erzeugt wird, als FEXT (Fernendnebensprechen) bezeichnet. Um diesen Parameter zu kompensieren, muss ein bestimmter Teil der normalen NEXT-Kompensation eine induktive Komponente aufweisen. Diese Komponente ist Teil der ersten Stufe des hier beschriebenen zweistufigen Kompensationsglieds. Dies geschieht in Abschnitt 30b der Klinkenfederdrähte unmittelbar jenseits der Überkreuzung 14. In dieser Kompensationsregion ist die Kompensation mit der Frequenz relativ konstant.

Ein wesentlicher Teil der NEXT-Kompensation der ersten Stufe ist kapazitive Kompensation und wird durch Verwendung der Kondensatoren 40a und 40b erzeugt. In den Fig. 4A und 4B weist dieser Teil der ersten Stufe eine minimale Verzögerung gegenüber dem Original-Nebensprechen auf, da er sich in einem Abschnitt der Leiterplatte 10 befindet, in dem er über den nicht Strom führenden Abschnitt 30a der Kontakte 30 elektrisch direkt mit dem Punkt verbunden ist, wo die Kontakte des Steckers 20 die Kontakte 30 berühren. Die Nettokompensation der ersten Stufe, also der kapazitive Abschnitt vor der Überkreuzung 14 zuzüglich des induktiven Abschnitts unmittelbar hinter der Überkreuzung 14, ist dem im Stecker erzeugten Nebensprechen entgegengesetzt. Die zweite Stufe weist gegenüber der ersten Stufe eine weitere Verzögerung auf, da sie in einem Abschnitt der Leiterplatte 10 liegt, der sich in einem Abstand von dem Punkt befindet, von dem aus die Kontakte des Steckers 20 die Kontakte 30 über den Strom führenden Abschnitt 30b der Kontakte 30 berühren. Sie hat eine Kompensationsrichtung, die mit derjenigen des Stecker-Nebensprechens übereinstimmt.

Die Interdigitalkondensatoren 40a, 40b sind als Teil der ersten Stufe auf den inneren metallischen Schichten angeordnet. Die Aufbauten der in Serie geschalteten L-C-Kombination befinden sich in der zweiten Stufe. Die Größenordnung der Kompensation der ersten Stufe, die überwiegend kapazitiv ist und über kein zusätzliches induktives Serienelement verfügt, ist über die Frequenz relativ flach. Die kapazitive Kompensation der zweiten Stufe hingegen ist so beschaffen, dass sie mit der Frequenz zunimmt, indem die in Serie geschaltete L-C-Kombination in die Leiterplattenschichten eingebaut ist. Infolgedessen nimmt das Nettokompensationsnebensprechen (erzeugtes Nebensprechen) des Steckverbinders, welches sich aus dem Kompensationsnebensprechen der ersten Stufe abzüglich des Kompensationsnebensprechens der zweiten Stufe ergibt, mit steigender Frequenz ab. Mit anderen Worten wird das Nettokompensationsnebensprechen in der Weise frequenzabhängig, dass die Erfindung bei hoher Frequenz einen geringeren Grad des Kompensationsnebensprechens bewirkt, als es normalerweise ohne eingebaute, in Serie geschaltete Induktionsspule der Fall wäre. Dadurch wird die Nebensprechüberkompensation in dem Steckverbinder bei hohen Frequenzen minimiert. Die frequenzabhängige Kompensation bewirkt bei niedriger Frequenz auch einen höheren Grad von Kompensationsnebensprechen, um die Nebensprechunterkompensation bei niedrigen Frequenzen im Steckverbinder zu minimieren. Durch Bereitstellung des Kompensationsnebensprechens auf niedrigem Niveau bei hoher Frequenz verbessert die Erfindung den Hochfrequenzbereich des Steckverbinders, wenn in die Buchse ein Niedrignebensprechstecker eingesteckt wird. Durch Bereitstellung des Kompensationsnebensprechens auf hohem Niveau bei niedriger Frequenz verbessert die Erfindung andererseits den Niederfrequenzbereich des Steckverbinders, wenn ein Hochnebensprechstecker in die Buchse eingesteckt wird.

Ein anderes Verfahren, um bei einem Frequenzanstieg eine höhere Wirkkapazität zu erreichen, besteht darin, die Eigenresonanzkennlinie eines Interdigitalkondensators zu nutzen, wie er in einem Artikel "Interdigital Capacitors and their Application to Lump-element Microwave Integrated Circuits" (Interdigitalkondensatoren und ihre Anwendung auf integrierte Mikrowellenschaltungen mit Ersatzschaltungselementen) von Gary D. Alley, IEEE Transactions on Microwave Theory and Techniques, Bd. MTT-18, Nr. 12, Dez. 1970, S. 1028-1033, beschrieben wird. In dem Artikel lehrt Alley, dass ein Interdigitalkondensator bei einer Frequenz, die sich aus seinem Längen-Breiten-Verhältnis ergibt, Eigenresonanz zeigt.

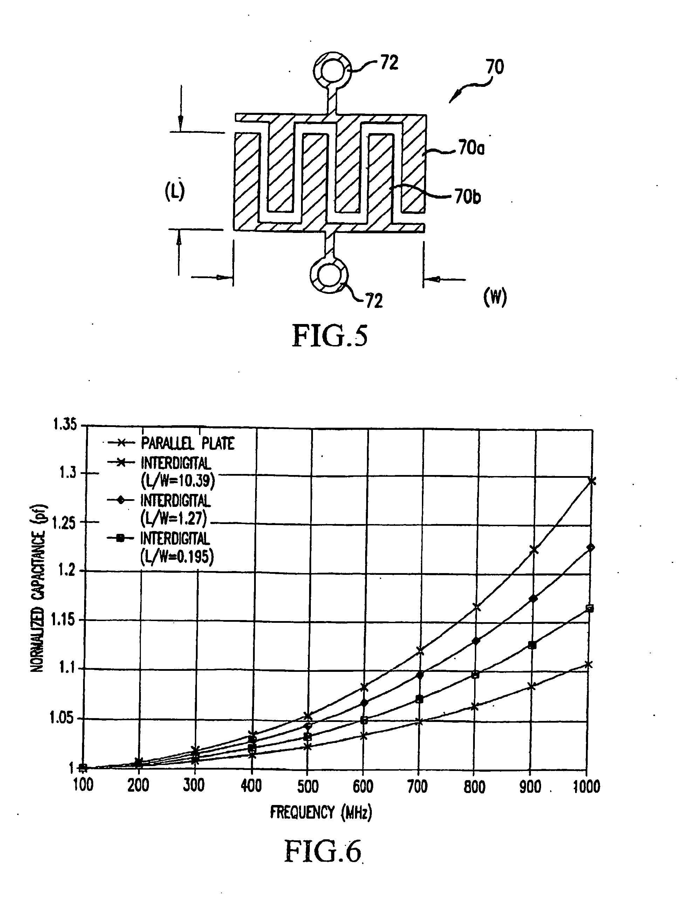

Wie in Fig. 5 dargestellt, weist ein Interdigitalkondensator 70 erste und zweite Kämme 70a, 70b, die ineinander greifen, sowie Anschlusskontakte 72 auf. Die Länge (L) und Breite (W) des Interdigitalkondensators wird gemäß Abbildung festgelegt. Mit zunehmendem Längen-Breiten-Verhältnis (L/W) des Interdigitalkondensators nimmt die Frequenz, bei der Resonanz auftritt, ab. Dies zeigt sich in einer schnelleren Zunahme der effektiven Kapazität über die gesamte betroffene Bandbreite, vorausgesetzt, dass die Resonanzfrequenz oberhalb dieser Bandbreite bleibt. Dies ist in Fig. 6 dargestellt, einer grafischen Darstellung des Verhältnisses effektive Kapazität/ Frequenzgang von Interdigitalkondensatoren mit unterschiedlichen L/ W-Verhältnissen. Diese grafische Darstellung zeigt das Ergebnis der Simulation durch die von Ansoft, Inc. angebotene Software "hfss" und vergleicht die Frequenzabhängigkeit unterschiedlicher Interdigitalkondensatorgeometrien sowie des Parallelplattenkondensators. Wie in Fig. 6 dargestellt, zeigt ein Interdigital-Langkondensator mit dem L/W-Verhältnis 10,39 die schnellste Zunahme der effektiven Kapazität bei steigender Frequenz, verglichen mit Interdigitalkondensatoren mit den L/W-Verhältnissen 1,27 und 0,195 sowie im Vergleich zu einem Parallelplattenkondensator. Alle Frequenzgänge in der Grafik wurden für diesen Vergleich auf 1 pF bei 100 MHz normiert.

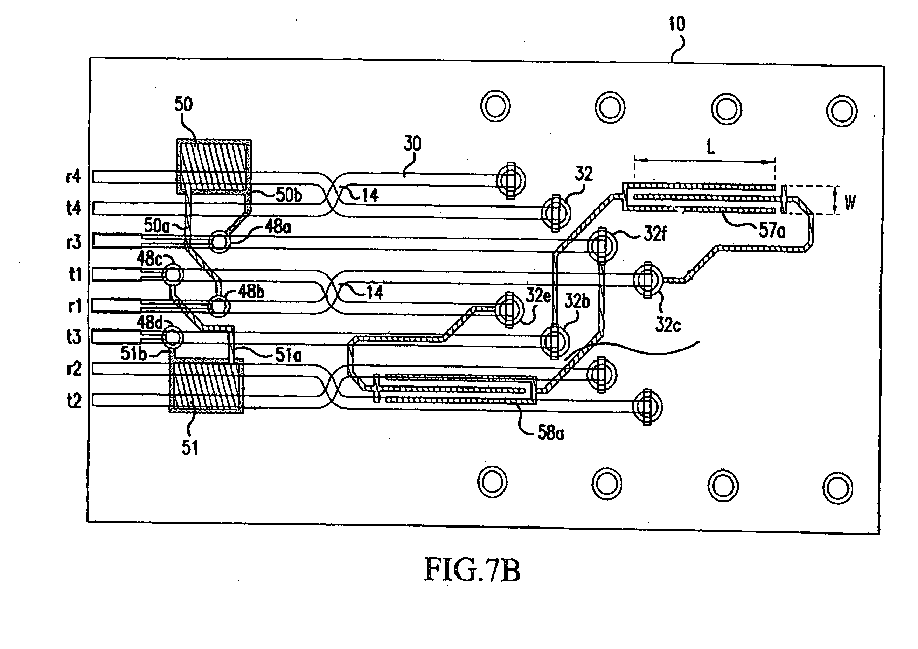

Die Eigenresonanzkennlinie eines Interdigital-Langkondensators, wie oben besprochen, wird zur Herbeiführung der NEXT-Kompensation in einem mehrstufigen Dämpfungssystem gemäß der zweiten Ausführungsform dieser Erfindung verwendet. Fig. 7A ist eine Seitenansicht eines Steckverbinders gemäß dieser zweiten Ausführungsform der Erfindung und Fig. 7B eine Draufsicht auf die Leiterplatte und die NEXT-Kompensationselemente nach Fig. 7A. Die zweite Ausführungsform ist mit der ersten identisch, außer dass andere Typen von NEXT-Kompensationselementen verwendet werden. Insbesondere werden die Kompensationskondensatoren der ersten Stufe mit Hilfe von ersten und zweiten Parallelplattenkondensatoren 50, 51 implementiert und die Kompensationselemente der zweiten Stufe mit Hilfe eines Paars von Interdigital-Langkondensatoren 57a, 58a sowie einem zweiten Paar von Interdigital-Langkondensatoren 57b, 58b implementiert. Ein Parallelplattenkondensator ist ein Kondensator, der aus zwei parallelen Metallplatten, jede mit einem anderen Potenzial, besteht, und ist als solcher bekannt.

Die beiden Platten 50a, 50b nach Fig. 7A des ersten Parallelplattenkondensators 50 werden auf den zweiten und dritten metallischen Schichten ML2 bzw. ML3 ausgebildet. In gleicher Weise werden die beiden Platten des zweiten Parallelplattenkondensators 51 auf den zweiten und dritten metallischen Schichten ML2 bzw.

ML3 ausgebildet. Die Platte 50a des Kondensators 50 ist über das plattierte Durchgangsloch 48b mit dem Minuspol r1 verbunden. Die Platte 50b des Kondensators 50 ist über das plattierte Durchgangsloch 48a mit dem Minuspol r3 verbunden. Auf ähnliche Weise sind die Platte 51a des zweiten Parallelplattenkondensators 51 über das plattierte Durchgangsloch 48c mit dem Pluspol t1 und die Platte 51b des Kondensators 51 über das plattierte Durchgangsloch 48d mit dem Pluspol t3 verbunden.

Das erste Paar von Interdigital-Langkondensatoren 57a, 58a ist als Teil der metallischen Schicht ML2 und das zweite Paar von Interdigital-Langkondensatoren 57b, 58b ist als Teil der dritten metallischen Schicht ML3 ausgebildet. Ein Ende jedes der Langkondensatoren 57a, 57b ist über das plattierte Durchgangsloch 32c mit dem Minuspol r1 elektrisch verbunden, wohingegen das andere Ende jedes der Langkondensatoren 57a, 57b über das plattierte Durchgangsloch 32b mit dem Pluspol t3 elektrisch verbunden ist. Daher sind die Interdigitalkondensatoren 57a, 57b elektrisch parallel geschaltet, um eine höhere Kapazität zu erreichen. Auf ähnliche Weise ist ein Ende jedes der Langkondensatoren 58a, 58b über das plattierte Durchgangsloch 32f elektrisch mit dem Minuspol r3 verbunden, wohingegen das andere Ende jedes der Langkondensatoren 58a, 58b über das plattierte Durchgangsloch 32e elektrisch mit dem Minuspol t1 verbunden ist. Daher sind die Kondensatoren 58a, 58b elektrisch parallel geschaltet, um eine höhere Kapazität zu erreichen.

Dementsprechend ist die Größenordnung der ersten kapazitiven Kompensationskopplung mit der Frequenz relativ flach, indem die Parallelplattenkondensatoren in die erste Stufe des Steckverbinders eingebaut werden. Die zweite Stufe der kapazitiven Kompensationskopplung nimmt mit der Frequenz zu, indem die Interdigital-Langkondensatoren mit hohen L/W-Verhältnissen in die zweite Stufe des Steckverbinders eingebaut werden. Infolgedessen geht das Nettokompensationsnebensprechen des Steckverbinders mit steigender Frequenz zurück.

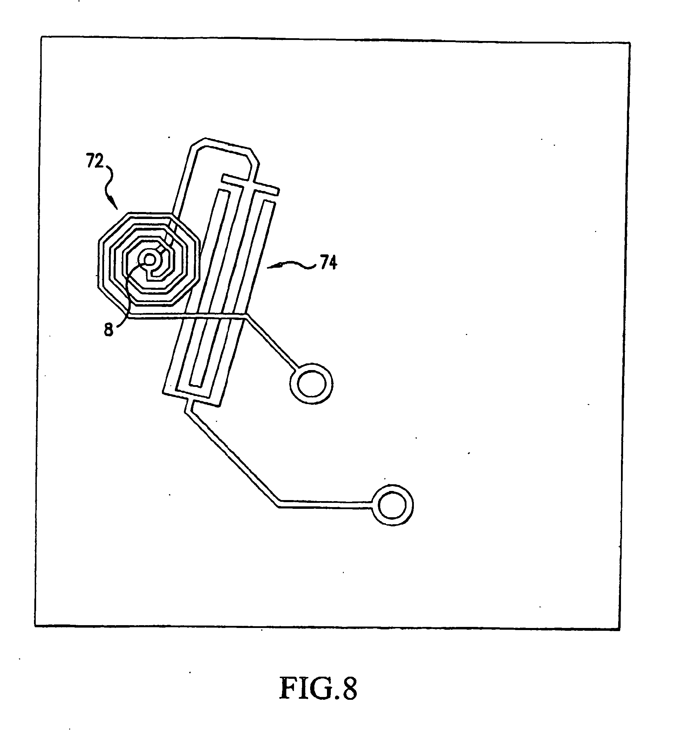

Bei einer dritten Ausführungsform der Erfindung werden die Methoden der ersten und zweiten Ausführungsformen kombiniert. Insbesondere werden bei der dritten Ausführungsform die Kompensationselemente der zweiten Stufe durch Verwendung eines Aufbaus mit in Serie geschalteter L-C-Kombination implementiert, wobei dieser Aufbau, wie er z. B. in Fig. 8 abgebildet ist, eine Spiralspule 72 aufweist, die mit einem Interdigital-Langkondensator 74 mit hohem L/W-Verhältnis in Serie geschaltet und auf der Leiterplatte 10 angeordnet ist. Mit anderen Worten, der Steckverbinder gemäß der dritten Ausführungsform ist identisch mit dem Steckverbinder gemäß der ersten Ausführungsform, die in den Figuren 4A und 4B dargestellt ist, außer dass jeder der Interdigitalkondensatoren der zweiten Stufe 46a, 46b; 56a, 56b ein Langkondensator ist, um ein hohes L/W-Verhältnis zu erreichen.

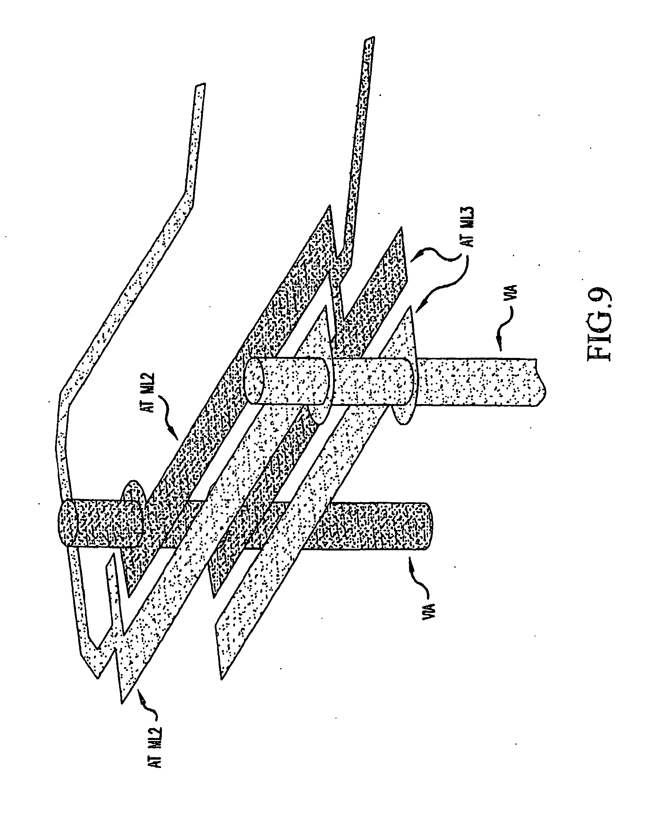

Bei einer vierten Ausführungsform und einer fünften Ausführungsform der Erfindung können die Verfahren der zweiten und dritten Ausführungsformen jeweils durch Verwendung eines gefalteten Interdigital-Langkondensators anstelle des in Fig. 8 abgebildeten Interdigitalkondensators mit hohem Schlankheitsverhältnis implementiert werden. Ein Beispiel eines gefalteten Interdigital-Langkondensators ist als Explosionszeichnung in Figur 9 dargestellt.

Im Einzelnen werden bei der vierten Ausführungsform die beiden gewöhnlichen Interdigital-Langkondensatoren 57a, 57b, die wie in den Fig. 7A und 7B der zweiten Ausführungsform dargestellt in den metallischen Schichten ML2 bzw. ML3 der Leiterplatte ausgebildet sind, durch einen gefalteten Interdigital-Langkondensator ersetzt, dessen Schichten wie in Fig. 9 angegeben in den metallischen Schichten ML2 und ML3 vorgesehen sind. In gleicher Weise werden die beiden gewöhnlichen Interdigital-Langkondensatoren 58a, 58b, die wie in den Fig. 7A und 7B der zweiten Ausführungsform dargestellt in den metallischen Schichten ML2 bzw. ML3 der Leiterplatte ausgebildet sind, durch einen gefalteten Interdigital-Langkondensator ersetzt, dessen Schichten wie in Fig. 9 angegeben in den metallischen Schichten ML2 und ML3 vorgesehen sind.

Die fünfte Ausführungsform ist mit der dritten Ausführungsform identisch, außer dass der in Fig. 9 der dritten Ausführungsform dargestellte gewöhnliche Interdigital-Langkondensator 74 durch einen gefalteten Interdigital-Langkondensator 78, wie in Fig. 10 dargestellt, ersetzt ist. Der gefaltete Interdigital-Langkondensator 78 hat den gleichen Aufbau wie der in Fig. 9 dargestellte gefaltete Interdigital-Langkondensator. Da die dritte Ausführungsform mit der in den Fig. 4A und 4B dargestellten ersten Ausführungsform, abgesehen von der Verwendung der in den Fig. 7A und 7B dargestellten Interdigital-Langkondensatoren, identisch ist, ist die fünfte Ausführungsform mit der in den Fig. 4A und 4B dargestellten ersten Ausführungsform einfach gesagt identisch, außer dass die Interdigitalkondensatoren 46a, 46b; 56a, 56b durch die gefalteten Interdigital-Langkondensatoren mit hohen L/W-Verhältnissen ersetzt wurden.

Insbesondere werden bei der fünften Ausführungsform die beiden gewöhnlichen Interdigitalkondensatoren 46a, 46b, die wie in den Fig. 4A und 4B der ersten Ausführungsform dargestellt in den metallischen Schichten ML2 und ML3 der Leiterplatte ausgebildet sind, durch einen gefalteten Interdigital-Langkondensator ersetzt, dessen Schichten in der ersten und zweiten metallischen Schicht ML1 und ML2 (wie z.B. in Fig. 9 dargestellt) vorgesehen sind. In gleicher Weise werden die beiden gewöhnlichen Interdigitalkondensatoren 56a, 56b, die wie in den Fig. 4A und 4B der zweiten Ausführungsform dargestellt in den metallischen Schichten ML2 und ML3 der Leiterplatte ausgebildet sind, durch einen gefalteten Interdigital-Langkondensator ersetzt, dessen Schichten in den metallischen Schichten ML2 and ML3 vorgesehen sind.

Fig. 11 ist eine grafische Darstellung, die als Beispiel das Verhältnis effektive Kapazität/ Frequenzgang der ersten, vierten und fünften Ausführungsform der Erfindung vergleicht. Diese grafische Darstellung zeigt das Ergebnis der mit der von Ansoft, Inc. angebotenen Software "hfss" erzeugten Simulation, wobei alle Frequenzgänge in der grafischen Darstellung für diesen Vergleich auf 1 pF bei 100 MHz normiert sind. Wie in Fig. 11 dargestellt, bewirkt die Kombination von Zylinderspule und gefaltetem Interdigital-Langkondensator, die in der zweiten Stufe gemäß der fünften Ausführungsform (Frequenzgang 80) in Serie geschaltet sind, eine Erhöhung der effektiven Kapazität mit der Frequenz, die größer ist, als es mit den Dämpfungsentwürfen gemäß der ersten Ausführungsform (Frequenzgang 81) oder vierten Ausführungsform (Frequenzgang 82) der Fall ist.

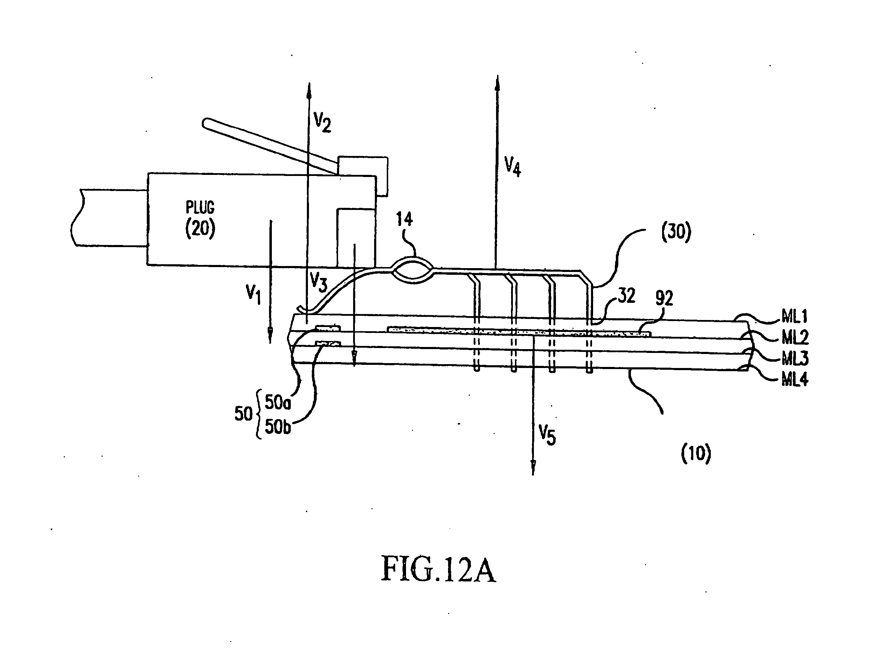

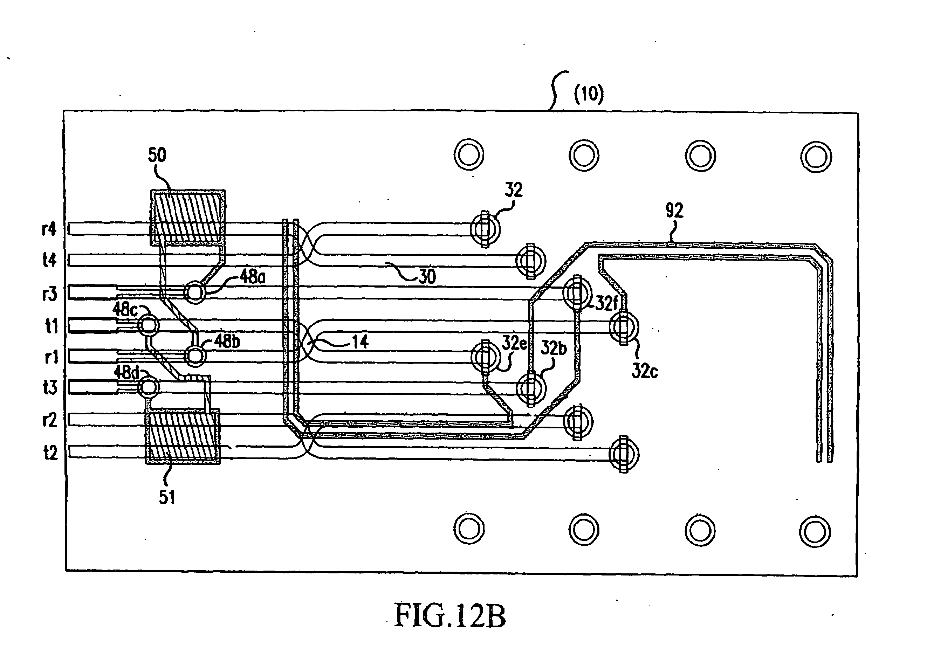

Fig. 12A ist eine Seitenansicht eines Steckverbinders gemäß einer sechsten Ausführungsform der Erfindung und Fig. 12B eine Draufsicht auf die Leiterplatte und die NEXT-Kompensationselemente nach Fig. 12B. Wie in den Fig. 12A und 12B dargestellt, ist diese sechste Ausführungsform mit der zweiten Ausführungsform identisch, außer dass die leerlaufenden Übertragungsleitungen 92 (92a, 92b, 92c und 92d) als Kompensationselemente der zweiten Stufe verwendet werden. In diesem Fall werden die Kompensationskondensatoren der ersten Stufe unter Verwendung der Parallelplattenkondensatoren 50, 51 wie in der zweiten Ausführungsform implementiert und die kapazitiven Kompensationselemente der zweiten Stufe unter Verwendung der Übertragungsleitungen 92 auf der zweiten metallischen Schicht ML2 der Leiterplatte 10. Bei dieser Ausführungsform erfolgt Resonanz bei der Frequenz, bei der die Länge der Übertragungsleitung 92 gleich einem Viertel der Wellenlänge der Resonanzfrequenz wird.

Wenngleich vierschichtige Leiterplattenaufbauten dargestellt werden, ist ohne weiteres erkennbar, dass für die Leiterplatte(n) jede andere Anzahl von Leiterplattensubstraten und/oder von metallischen Schichten verwendet werden kann. Der daraus resultierende erfindungsgemäße Steckverbinder kann mit Gehäusen, Schneidklemmsteckverbindern, Steckfederkontakten usw. kombiniert werden. Ebenso können die verschiedenen Konfigurationen und Merkmale der obigen Ausführungsformen mit denjenigen anderer Ausführungsformen kombiniert oder durch diese ersetzt werden. Wo Interdigitalkondensatoren verwendet werden, können stattdessen auch Plattenkondensatoren oder Einzelkondensatoren verwendet werden. Ebenso können die Induktionsspulen mit anderen Geometrien als die in Fig. 4B dargestellten Spiralpule implementiert werden, wie zum Beispiel als Ovalspirale, Quadratspirale, Rechteckspirale, Zylinderspule oder diskrete Spule. Wenn die Interdigitalkondensatoren eingesetzt werden, können solche Kondensatoren gegenüber den entsprechenden anderen Interdigitalkondensatoren dupliziert werden. In einem Steckverbinder können einige der Interdigitalkondensatoren auf einer einzigen metallischen Schicht oder auf mehreren metallischen Schichten implementiert werden.

Wenngleich die Erfindung anhand der in den oben beschriebenen Zeichnungen dargestellten Ausführungsformen erläutert wurde, dürfte dem normalen Fachmann klar sein, dass sich die Erfindung nicht auf diese Ausführungsformen beschränkt, sondern dass verschiedene Änderungen oder Modifikationen derselben möglich sind. .

**Patentansprüche**

1. Steckverbinder zur Reduzierung des Nebensprechens, wobei der Steckverbinder umfasst:

   - eine Leiterplatte (10), die eine Mehrzahl von Substraten (S1, S2, S3) und eine Mehrzahl von metallischen Schichten (ML1, ML2, ML3, ML4) aufweist, die abwechselnd gestapelt sind ;
   - eine erste Kompensationsschaltung (40a, 40b; 50, 51); und
   - eine zweite Kompensationsschaltung (44, 46, 54, 56; 70; 57a, 57b, 58a, 58b; 72, 74; 72, 78; 92); , **dadurch gekennzeichnet, dass**:
   - die erste Kompensationsschaltung (40a, 40b; 50, 51) in einem ersten Teilbereich (48b) der Leiterplatte (10) auf wenigstens einer metallischen Schicht (ML1; ML2, ML3, ML4) der Leiterplatte (10) vorgesehen und mit einer ersten Leiterbahn (r1) einer Vielzahl von Leiterbahnen (t1, r1, t2, r2, t3, r3, t4, r4) verbunden ist und
   - die zweite Kompensationsschaltung (44, 46, 54, 56; 70; 57a, 57b, 58a, 58b; 72, 74; 72, 78; 92) in einem zweiten Teilbereich (32c) der Leiterplatte (10) vorgesehen und mit der ersten Leiterbahn (r1) der Vielzahl von Leiterbahnen (t1, r1, t2, r2, t3, r3, t4, r4) verbunden ist, wobei die erste Kompensationsschaltung (40a, 40b; 50, 51) eine relativ flache effektive Kapazität, während die zweite Kompensationsschaltung (44, 46 , 54, 56; 70; 57a, 57b, 58a, 58b; 72, 74; 72, 78; 92) eine Zunahme der Kapazität mit zunehmende Frequenz aufweist.

2. Steckverbinder nach Anspruch 1, **dadurch gekennzeichnet, dass** die zweite Kompensationsschaltung wenigstens eine in Serie geschaltete Induktionsspulen-Kondensator-Kombination (L, C) aufweist.

3. Steckverbinder nach Anspruch 2, **dadurch gekennzeichnet, dass** die Tnduktionsspule (L) auf, über oder unter einer äußeren metallischen Schicht (ML1, ML4) der Leiterplatte (10) oder im Innern der Leiterplatte (10) angeordnet ist.

4. Steckverbinder nach Anspruch 3, **dadurch gekennzeichnet, dass** die Induktionsspule (L) eine Spiralspule ist.

5. Steckverbinder nach Anspruch 3, dadurch gekennzeichnet, dass der wenigstens eine Kondensator (C) umfasst:

   - einen ersten Interdigitalkondensator (46), der mit der Induktionsspule (44) in Serie geschaltet und auf einer ersten metallischen Schicht der Leiterplatte (10) angeordnet ist, und
   - einen zweiten Interdigitalkondensator (56), der mit der Induktionsspule (54) in Serie geschaltet und auf einer zweiten metallischen Schicht der Leiterplatte (10) angeordnet ist.

6. Steckverbinder nach Anspruch 2, **dadurch gekennzeichnet, dass** die erste Kompensationsschaltung wenigstens einen Interdigitalkondensator (40) oder wenigstens einen Parallelplattenkondensator (50) aufweist.

7. Steckverbinder nach Anspruch 1, **dadurch gekennzeichnet, dass** die zweite Kompensationsschaltung wenigstens einen Interdigital-Langkondensator (70) auf wenigstens einer metallischen Schicht der Leiterplatte (10) aufweist.

8. Steckverbinder nach Anspruch 7, **dadurch gekennzeichnet, dass** die erste Kompensationsschaltung wenigstens einen Interdigitalkondensator (40) oder wenigstens einen Parallelplattenkondensator (50) aufweist.

9. Steckverbinder nach Anspruch 7, **dadurch gekennzeichnet, dass** die zweite Kompensationsschaltung wenigstens einen gefalteten Interdigital-Langkondensator (78) aufweist.

10. Steckverbinder nach Anspruch 8, **dadurch gekennzeichnet, dass** die erste Kompensationsschaltung wenigstens einen Interdigitalkondensator (40) oder wenigstens einen Parallelplattenkondensator (50) aufweist.

11. Steckverbinder nach Anspruch 2, **dadurch gekennzeichnet, dass** der wenigstens eine Kondensator (C) der in Serie geschalteten Induktionsspulen-Kondensator-Kombination (L, C) wenigstens ein Interdigital-Langkondensator (74) auf wenigstens einer metallischen Schicht der Leiterplatte (10) ist.

12. Steckverbinder nach Anspruch 11, **dadurch gekennzeichnet, dass** die erste Kompensationsschaltung wenigstens einen Interdigitalkondensator (40) oder wenigstens einen Parallelplattenkondensator (50) aufweist.

13. Steckverbinder nach Anspruch 11, **dadurch ge-**

**kennzeichnet, dass** der wenigstens eine Interdigital-Langkondensator ein gefalteter Interdigital-Langkondensator (78) ist.

14. Steckverbinder nach Anspruch 13, **dadurch gekennzeichnet, dass** die erste Kompensationsschaltung wenigstens einen Interdigitulkondensator (40) oder wenigstens einen Parallelplattenkondensator (50) aufweist.

15. Steckverbinder nach Anspruch 1, **dadurch gekennzeichnet, dass** die zweite Kompensationsschaltung wenigstens eine leerlaufende Übertragungsleitung (92) auf wenigstens einer metallischen Schicht der Leiterplatte (10) aufweist.

16. Steckverbindern nach Anspruch 15, **dadurch gekennzeichnet, dass** die erste Kompensationsschaltung wenigstens einen Interdigitalkondensator (40) oder wenigstens einen Parallelplattenkondensator (50) aufweist.

17. Steckverbinder nach Anspruch 2, **dadurch gekennzeichnet, dass** der wenigstens eine mit der Induktionsspule (2) in der zweiten Kompensationsschaltung in Serie geschaltete Kondensator (C) wenigstens ein Parallelplattenkondensator ist.

18. Steckverbinder nach Anspruch 1, **dadurch gekennzeichnet, dass** er wenigstens einen leitenden Kontakt (30) auf der Leiterplatte (10) aufweist.

19. Steckverbinder nach Anspruch 18, **dadurch gekennzeichnet, dass** die zweite Kompensationsschaltung wenigstens eine in Serie geschaltete Induktionsspulen-Kondensator-Kombination (L, C) aufweist, die eine Induktionsspule (L) und wenigstens einen mit der Induktionsspule in Serie geschalteten Kondensator (C) umfasst.

20. Steckverbinder nach Anspruch 19, **dadurch gekennzeichnet, dass** die Induktionsspule (L) auf oder über oder unter einer äußeren metallischen Schicht der Leiterplatte (10) oder im Innern der Leiterplatte (10) angeordnet ist.

21. Steckverbinder nach Anspruch 20, **dadurch gekennzeichnet, dass** die Induktionsspule eine Spiralspule (44, 54) ist.

22. Steckverbinder nach Anspruch 20, **dadurch gekennzeichnet, dass** der wenigstens eine Kondensator (C) umfasst:

    - einen ersten Interdigitalkondensator (46), der mit der Induktionsspule (44) in Serie geschaltet und auf einer ersten metallischen Schicht der Leiterplatte (10) angeordnet ist, und

    - einen zweiten Interdigitalkondensator (56), der mit der Induktionsspule (54) in Serie geschaltet und auf einer zweiten metallischen Schicht der Leiterplatte (10) angeordnet ist.

23. Steckverbinder nach Anspruch 19, **dadurch gekennzeichnet, dass** die erste Kompensationsschaltung wenigstens einen Interdigitalkondensator (40) oder wenigstens einen Parallelplattenkondensator (50) aufweist.

24. Steckverbinder nach Anspruch 18, **dadurch gekennzeichnet, dass** die zweite Kompensationsschaltung wenigstens einen Interdigital-Langkondensator (57, 58) auf wenigstens einer metallischen Schicht der Leiterplatte (10) aufweist.

25. Steckverbinder nach Anspruch 24, **dadurch gekennzeichnet, dass** die erste Kompensationsschaltung wenigstens einen Interdigitalkondensator (40) oder wenigstens einen Parallelplattenkondensator (50) aufweist.

26. Steckverbinder nach Anspruch 24, **dadurch gekennzeichnet, dass** der wenigstens eine Interdigital-Langkondensator ein gefalteter Interdigital-Langkondensator (78) ist.

27. Steckverbinder nach Anspruch 26, **dadurch gekennzeichnet, dass** die erste Kompensationsschaltung wenigstens einen Interdigitalkondensator (40) oder wenigstens einen Parallelplattenkondensator (50) aufweist.

28. Steckverbinder nach Anspruch 19, **dadurch gekennzeichnet, dass** der wenigstens eine Kondensator (C) der in Serie geschalteten Induktionsspulen-Kondensator-Kombination (L, C) wenigstens ein Interdigital-Langkondensator (78) auf wenigstens einer metallischen Schicht der Leiterplatte (10) ist.

29. Steckverbinder nach Anspruch 28, **dadurch gekennzeichnet, dass** die erste Kompensationsschaltung wenigstens einen Interdigitalkondensator (40) oder wenigstens einen Parallelplattenkondensator (50) aufweist.

30. Steckverbinder nach Anspruch 28, **dadurch gekennzeichnet, dass** der wenigstens eine Interdigital-Langkondensator ein gefalteter Interdigital-Langkondensator (78) ist.

31. Steckverbinder nach Anspruch 30, **dadurch gekennzeichnet, dass** die erste Kompensationsschaltung wenigstens einen Interdigitalkondensator (40) oder wenigstens einen Parallelplattenkondensator (50) aufweist.

**32.** Steckverbinder nach Anspruch 18 **dadurch gekennzeichnet, dass** die zweite Kompensationsschaltung wenigstens eine leerlaufende Übertragungsleitung (92) auf wenigstens einer metallischen Schicht der Leiterplatte (10) aufweist.

**33.** Steckverbinder nach Anspruch 32, **dadurch gekennzeichnet, dass** die erste Kompensationsschaltung wenigstens einen Interdigitalkondensator (40) oder wenigstens einen Parallelplattenkondensator (50) aufweist.

**34.** Steckverbinder nach Anspruch 19, **dadurch gekennzeichnet, dass** der wenigstens eine mit der Induktionsspule (4) in der zweiten Kompensationsschaltung in Serie geschaltete Kondensator (C) wenigstens ein Parallelplattenkondensator ist.

**Claims**

**1.** Plug-in connector for reducing crosstalk, whereby the plug-in connector comprises:

- a circuit board (10), comprising a plurality of substrates (S1, S2, S3) and a plurality of metal layers (ML1, ML2, ML3, ML4) stacked in alternation;
- a first compensation circuit (40a, 40b; 50, 51); and
- a second compensation circuit (44, 46, 54, 56; 70; 57a, 57b, 58a, 58b; 72, 74; 72, 78; 92), **characterized in that**
- the first compensation circuit (40a, 40b; 50, 51) is provided in a first partial region (48b) of the circuit board (10) on at least one metal layer (ML1; ML2, ML3, ML4) of the circuit board (10) and is connected with a first track (r1) of a plurality of tracks (t1, r1, t2, r2, t3, r3, t4, r4), and
- the second compensation circuit (44, 46, 54, 56; 70; 57a, 57b, 58a, 58b; 72, 74; 72, 78; 92) is provided in a second partial region (32c) of the circuit board (10) and is connected with the first track (r1) of the plurality of tracks (t1, r1, t2, r2, t3, r3, t4, r4), whereby the first compensation circuit (40a, 40b; 50, 51) exhibits a relatively flat effective capacitance, whereas the second compensation circuit (44, 46, 54, 56; 70; 57a, 57b, 58a, 58b; 72, 74; 72, 78; 92) exhibits an increase in capacitance with rising frequency.

**2.** Plug-in connector according to Claim 1, **characterized in that** the second compensation circuit comprises at least one combination of an induction coil and capacitor (L, C) connected in series.

**3.** Plug-in connector according to Claim 2, **characterized in that** the induction coil (L) is arranged on, above or underneath an outer metal layer (ML1, ML4) of the circuit board (10) or is arranged inside the circuit board (10).

**4.** Plug-in connector according to Claim 3, **characterized in that** the induction coil (L) is a spiral coil.

**5.** Plug-in connector according to Claim 3, **characterized in that** the at least one capacitor (C) comprises:

- a first interdigital capacitor (46) that is connected in series with the induction coil (44) and is arranged on a first metal layer of the circuit board (10), and
- a second interdigital capacitor (56) that is connected in series with the induction coil (54) and is arranged on a second metal layer of the circuit board (10).

**6.** Plug-in connector according to Claim 2, **characterized in that** the first compensation circuit comprises at least one interdigital capacitor (40) or at least one parallel-plate capacitor (50).

**7.** Plug-in connector according to Claim 1, **characterized in that** the second compensation circuit comprises at least one elongated interdigital capacitor (70) on at least one metal layer of the circuit board (10).

**8.** Plug-in connector according to Claim 7, **characterized in that** the first compensation circuit comprises at least one interdigital capacitor (40) or at least one parallel-plate capacitor (50).

**9.** Plug-in connector according to Claim 7, **characterized in that** the second compensation circuit comprises at least one folded, elongated interdigital capacitor (78).

**10.** Plug-in connector according to Claim 8, **characterized in that** the first compensation circuit comprises at least one interdigital capacitor (40) or at least one parallel-plate capacitor (50).

**11.** Plug-in connector according to Claim 2, **characterized in that** the at least one capacitor (C) of the series-connected induction coil-capacitor combination (L, C) is at least one elongated interdigital capacitor (74) on at least one metal layer of the circuit board (10).

**12.** Plug-in connector according to Claim 11, **characterized in that** the first compensation circuit comprises at least one interdigital capacitor (40) or at least one parallel-plate capacitor (50).

**13.** Plug-in connector according to Claim 11, **character-**

**ized in that** the at least one elongated, interdigital capacitor is a folded, elongated interdigital capacitor (78).

14. Plug-in connector according to Claim 13, **characterized in that** the first compensation circuit comprises at least one interdigital capacitor (40) or at least one parallel-plate capacitor (50).

15. Plug-in connector according to Claim 1, **characterized in that** the second compensation circuit comprises at least one open-circuited transmission line (92) on at least one metal layer of the circuit board (10).

16. Plug-in connector according to Claim 15, **characterized in that** the first compensation circuit comprises at least one interdigital capacitor (40) or at least one parallel-plate capacitor (50).

17. Plug-in connector according to Claim 2, **characterized in that** the at least one capacitor (C) that is connected in series with the induction coil (2) in the second compensation circuit is at least one parallel-plate capacitor.

18. Plug-in connector according to Claim 1, **characterized in that** it comprises at least one conductive contact (30) on the circuit board (10).

19. Plug-in connector according to claim 18, **characterized in that** second compensation circuit comprises at least one combination of an induction coil and the capacitor (L, C) connected in series, comprising an induction coil (L) and at least one capacitor (C) connected in series with the induction coil.

20. Plug-in connector according to Claim 19, **characterized in that** the induction coil (L) is arranged on, above or underneath an outer metal layer of the circuit board (10) or is arranged inside the circuit board (10).

21. Plug-in connector according to Claim 20, **characterized in that** the induction coil is a spiral coil (44, 54).

22. Plug-in connector according to Claim 20, **characterized in that** the at least one capacitor (C) comprises:

>   - a first interdigital capacitor (46) that is connected in series with the induction coil (44) and is arranged on a first metal layer of the circuit board (10), and
>   - a second interdigital capacitor (56) that is connected in series with the induction coil (54) and is arranged on a second metal layer of the circuit board (10).

23. Plug-in connector according to Claim 19, **characterized in that** the first compensation circuit comprises at least one interdigital capacitor (40) or at least one parallel-plate capacitor (50).

24. Plug-in connector according to Claim 18, **characterized in that** the second compensation circuit comprises at least one elongated interdigital capacitor (57, 58) on at least one metal layer of the circuit board (10).

25. Plug-in connector according to Claim 24, **characterized in that** the first compensation circuit comprises at least one interdigital capacitor (40) or at least one parallel-plate capacitor (50).

26. Plug-in connector according to Claim 24, **characterized in that** the at least one elongated, interdigital capacitor is a folded, elongated interdigital capacitor (78).

27. Plug-in connector according to Claim 26, **characterized in that** the first compensation circuit comprises at least one interdigital capacitor (40) or at least one parallel-plate capacitor (50).

28. Plug-in connector according to Claim 19, **characterized in that** the at least one capacitor (C) of the series-connected induction coil-capacitor combination (L, C) is at least one elongated interdigital capacitor (78) on at least one metal layer of the circuit board (10).

29. Plug-in connector according to Claim 28, **characterized in that** the first compensation circuit comprises at least one interdigital capacitor (40) or at least one parallel-plate capacitor (50).

30. Plug-in connector according to Claim 28, **characterized in that** the at least one elongated, interdigital capacitor is a folded, elongated interdigital capacitor (78).

31. Plug-in connector according to Claim 30, **characterized in that** the first compensation circuit comprises at least one interdigital capacitor (40) or at least one parallel-plate capacitor (50).

32. Plug-in connector according to Claim 18, **characterized in that** the second compensation circuit comprises at least one open-circuited transmission line (92) on at least one metal layer of the circuit board (10).

33. Plug-in connector according to Claim 32, **characterized in that** the first compensation circuit comprises at least one interdigital capacitor (40) or at least one parallel-plate capacitor (50).

**34.** Plug-in connector according to Claim 19, **characterized in that** the at least one capacitor (C) that is connected in series with the induction coil (4) in the second compensation circuit is at least one parallel-plate capacitor.

## Revendications

**1.** Connecteur pour réduire la diaphonie, lequel connecteur comprend :

- une carte de circuit imprimé (10) qui présente une pluralité de substrats (S1, S2, S3) et une pluralité de couches métalliques (ML1, ML2, ML3, ML4) qui sont empilés en alternance ;
- un premier circuit de compensation (40a, 40b ; 50, 51) ; et
- un deuxième circuit de compensation (44, 46, 54, 56 ; 70, 57a, 57b, 58a, 58b ; 72, 74 ; 72, 78 ; 92) ; **caractérisé en ce que** :
- le premier circuit de compensation (40a, 40b ; 50, 51) est prévu dans une première zone partielle (48b) de la carte de circuit imprimé (10) sur au moins une couche métallique (ML1, ML2, ML3, ML4) de la carte de circuit imprimé (10) et relié à une première piste conductrice (r1) d'une pluralité de pistes conductrices (t1, r1, t2, r2, t3, r3, t4, r4) et
- le deuxième circuit de compensation (44, 46, 54, 56 ; 70, 57a, 57b, 58a, 58b ; 72, 74 ; 72, 78 ; 92) est prévu dans une deuxième zone partielle (32c) de la carte de circuit imprimé (10) et relié à la première piste conductrice (r1) de la pluralité de pistes conductrices (t1, r1, t2, r2, t3, r3, t4, r4), le premier circuit de compensation (40a, 40b ; 50, 51) présentant une capacité effective relative plate tandis que le deuxième circuit de compensation (44, 46, 54, 56 ; 70, 57a, 57b, 58a, 58b ; 72, 74 ; 72, 78 ; 92) présente une augmentation de la capacité lorsque la fréquence augmente.

**2.** Connecteur selon la revendication 1, **caractérisé en ce que** le deuxième circuit de compensation présente au moins une combinaison bobine d'induction-condensateur (L, C) branchée en série.

**3.** Connecteur selon la revendication 2, **caractérisé en ce que** la bobine d'induction (L) est disposée sur, au-dessus ou au-dessous d'une couche métallique extérieure (ML1, ML4) de la carte de circuit imprimé (10) ou à l'intérieur de la carte de circuit imprimé (10).

**4.** Connecteur selon la revendication 3, **caractérisé en ce que** la bobine d'induction (L) est une bobine hélicoïdale.

**5.** Connecteur selon la revendication 3, **caractérisé en ce que** ledit au moins un condensateur (C) comprend :

- un premier condensateur interdigital (46) qui est branché en série avec la bobine d'induction (44) et disposé sur une première couche métallique de la carte de circuit imprimé (10), et
- un deuxième condensateur interdigital (56) qui est branché en série avec la bobine d'induction (54) et disposé sur une deuxième couche métallique de la carte de circuit imprimé (10).

**6.** Connecteur selon la revendication 2, **caractérisé en ce que** le premier circuit de compensation présente au moins un condensateur interdigital (40) ou au moins un condensateur à plaques parallèles (50).

**7.** Connecteur selon la revendication 1, **caractérisé en ce que** le deuxième circuit de compensation présente au moins un condensateur interdigital long (70) sur au moins une couche métallique de la carte de circuit imprimé (10).

**8.** Connecteur selon la revendication 7, **caractérisé en ce que** le premier circuit de compensation présente au moins un condensateur interdigital (40) ou au moins un condensateur à plaques parallèles (50).

**9.** Connecteur selon la revendication 7, **caractérisé en ce que** le deuxième circuit de compensation présente au moins un condensateur interdigital long plié (78).

**10.** Connecteur selon la revendication 8, **caractérisé en ce que** le premier circuit de compensation présente au moins un condensateur interdigital (40) ou au moins un condensateur à plaques parallèles (50).

**11.** Connecteur selon la revendication 2, **caractérisé en ce que** ledit au moins un condensateur (C) de la combinaison bobine d'induction-condensateur (L, C) branchée en série est au moins un condensateur interdigital long (74) sur au moins une couche métallique de la carte de circuit imprimé (10).

**12.** Connecteur selon la revendication 11, **caractérisé en ce que** le premier circuit de compensation présente au moins un condensateur interdigital (40) ou au moins un condensateur à plaques parallèles (50).

**13.** Connecteur selon la revendication 11, **caractérisé en ce que** ledit au moins un condensateur interdigital long est un condensateur interdigital long plié (78).

**14.** Connecteur selon la revendication 13, **caractérisé en ce que** le premier circuit de compensation présente au moins un condensateur interdigital (40) ou au moins un condensateur à plaques parallèles (50).

15. Connecteur selon la revendication 1, **caractérisé en ce que** le deuxième circuit de compensation présente au moins une ligne de transmission (92) ouverte à une extrémité sur au moins une couche métallique de la carte de circuit imprimé (10).

16. Connecteur selon la revendication 15, **caractérisé en ce que** le premier circuit de compensation présente au moins un condensateur interdigital (40) ou au moins un condensateur à plaques parallèles (50).

17. Connecteur selon la revendication 2, **caractérisé en ce que** ledit au moins un condensateur (C) branché en série avec la bobine d'induction (2) dans le deuxième circuit de compensation est au moins un condensateur à plaques parallèles.

18. Connecteur selon la revendication 1, **caractérisé en ce qu'**il présente au moins un contact conducteur (30) sur la carte de circuit imprimé (10).

19. Connecteur selon la revendication 18, **caractérisé en ce que** le deuxième circuit de compensation présente au moins une combinaison bobine d'induction-condensateur (L, C) branchée en série qui comprend une bobine d'induction (L) et au moins un condensateur (C) branché en série avec la bobine d'induction.

20. Connecteur selon la revendication 19, **caractérisé en ce que** la bobine d'induction (L) est disposée sur, au-dessus ou au dessous d'une couche métallique extérieure de la carte de circuit imprimé (10) ou à l'intérieur de la carte de circuit imprimé (10).

21. Connecteur selon la revendication 20, **caractérisé en ce que** la bobine d'induction est une bobine hélicoïdale (44, 54).

22. Connecteur selon la revendication 20, **caractérisé en ce que** ledit au moins un condensateur (C) comprend :

   - un premier condensateur interdigital (46) qui est branché en série avec la bobine d'induction (44) et disposé sur une première couche métallique de la carte de circuit imprimé (10), et
   - un deuxième condensateur interdigital (56) qui est branché en série avec la bobine d'induction (54) et disposé sur une deuxième couche métallique de la carte de circuit imprimé (10).

23. Connecteur selon la revendication 19, **caractérisé en ce que** le premier circuit de compensation présente au moins un condensateur interdigital (40) ou au moins un condensateur à plaques parallèles (50).

24. Connecteur selon la revendication 18, **caractérisé en ce que** le deuxième circuit de compensation présente au moins un condensateur interdigital long (57, 58) sur au moins une couche métallique de la carte de circuit imprimé (10).

25. Connecteur selon la revendication 24, **caractérisé en ce que** le premier circuit de compensation présente au moins un condensateur interdigital (40) ou au moins un condensateur à plaques parallèles (50).

26. Connecteur selon la revendication 24, **caractérisé en ce que** ledit au moins un condensateur interdigital long est un condensateur interdigital long plié (78).

27. Connecteur selon la revendication 26, **caractérisé en ce que** le premier circuit de compensation présente au moins un condensateur interdigital (40) ou au moins un condensateur à plaques parallèles (50).

28. Connecteur selon la revendication 19, **caractérisé en ce que** ledit au moins un condensateur (C) de la combinaison bobine d'induction-condensateur (L, C) branchée en série est au moins un condensateur interdigital long (78) sur au moins une couche métallique de la carte de circuit imprimé (10).

29. Connecteur selon la revendication 28, **caractérisé en ce que** le premier circuit de compensation présente au moins un condensateur interdigital (40) ou au moins un condensateur à plaques parallèles (50).

30. Connecteur selon la revendication 28, **caractérisé en ce que** ledit au moins un condensateur interdigital long est un condensateur interdigital long plié (78).

31. Connecteur selon la revendication 30, **caractérisé en ce que** le premier circuit de compensation présente au moins un condensateur interdigital (40) ou au moins un condensateur à plaques parallèles (50).

32. Connecteur selon la revendication 18, **caractérisé en ce que** le deuxième circuit de compensation présente au moins une ligne de transmission (92) ouverte à une extrémité sur au moins une couche métallique de la carte de circuit imprimé (10).

33. Connecteur selon la revendication 32, **caractérisé en ce que** le premier circuit de compensation présente au moins un condensateur interdigital (40) ou au moins un condensateur à plaques parallèles (50).

34. Connecteur selon la revendication 19, **caractérisé en ce que** ledit au moins un condensateur (C) branché en série avec la bobine d'induction (4) dans le deuxième circuit de compensation est au moins un condensateur à plaques parallèles.

L                    C

FIG.1

(L)

8

(C)

(10)

FIG.2

FIG.3

FIG.4A

EP 1 596 478 B1

FIG.4B

FIG.5

FIG.6

FIG.7A

EP 1 596 478 B1

FIG.7B

FIG.8

EP 1 596 478 B1

AT ML2

AT ML2

VIA

AT ML3

VIA

FIG.9

FIG.10

FIG.11

FIG.12A

EP 1 596 478 B1

FIG.12B

EP 1 596 478 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5997358 A
- US 5915989 A
- US 6042427 A
- US 6050843 A
- US 6270381 A
- US 6379157 B

**In der Beschreibung aufgeführte Nicht-Patentliteratur**

- **GARY D. ALLEY.** Interdigital Capacitors and their Application to Lump-element Microwave Integrated Circuits. *IEEE Transactions on Microwave Theory and Techniques,* Dezember 1970, vol. MTT-18 (12), 1028-1033